# EUROPÄISCHE PATENTANMELDUNG

(11) **EP 4 394 422 A1**
(43) Veröffentlichungstag der Anmeldung: **03.07.2024**
(21) Anmeldenummer: 22216988.0
(22) Anmeldetag: 28.12.2022
(51) Int. Cl.: G01R 33/3873

(54) **SHIMKASTEN FÜR EINE GRADIENTENSPULENEINHEIT EINES MR-SYSTEMS**

(71) Anmelder: Siemens Healthineers AG, 91301 Forchheim (DE)
(72) Erfinder: Biber, Stephan, 91056 Erlangen (DE)
(74) Vertreter: Siemens Healthineers Patent Attorneys

(57) **Zusammenfassung**

Die Erfindung betrifft einen Shimkasten ausgebildet zum Einschieben in eine Shimkastenaufnahme einer
Gradientenspuleneinheit,
welcher Shimkasten längsförmig mit einer Länge in Längsrichtung, einer Höhe in radialer Richtung und einer Breite in Umfangsrichtung ausgebildet ist,
aufweisend zumindest zwei Shimtaschen jeweils ausgebildet zum Aufnehmen von zumindest zwei Shimplättchen,
und umfassend zumindest zwei in radialer Richtung übereinander angeordnete Shimplättchen in einer Shimtasche, wobei die Oberflächen der zumindest zwei Shimplättchen eine isolierende Beschichtung aufweisen.

## Beschreibung

Die Erfindung betrifft einen Shimkasten, eine Gradientenspuleneinheit und ein Magnetresonanzgerät.

In einem Magnetresonanzgerät wird üblicherweise der zu untersuchende Körper eines Untersuchungsobjektes, insbesondere eines Patienten, mit Hilfe eines Hauptmagneten einem relativ hohen Hauptmagnetfeld, beispielsweise von 1,5 oder 3 oder 7 Tesla, ausgesetzt. Zusätzlich werden mit Hilfe einer Gradientenspuleneinheit Gradientenpulse ausgespielt. Über eine Hochfrequenzantenneneinheit werden dann mittels geeigneter Antenneneinrichtungen hochfrequente Hochfrequenz-Pulse, beispielsweise Anregungspulse, ausgesendet, was dazu führt, dass die Kernspins bestimmter, durch diese Hochfrequenz-Pulse resonant angeregter Atome um einen definierten Flipwinkel gegenüber den Magnetfeldlinien des Hauptmagnetfelds verkippt werden. Bei der Relaxation der Kernspins werden Hochfrequenz-Signale, so genannte Magnetresonanz-Signale, abgestrahlt, die mittels geeigneter Hochfrequenzantennen empfangen und dann weiterverarbeitet werden. Aus den so akquirierten Rohdaten können schließlich die gewünschten Bilddaten rekonstruiert werden.

Für eine bestimmte Messung ist daher eine bestimmte Magnetresonanz-Steuerungssequenz (MR-Steuerungssequenz), auch Pulssequenz genannt, auszusenden, welche aus einer Folge von Hochfrequenz-Pulsen, beispielsweise Anregungspulsen und Refokussierungspulsen, sowie passend dazu koordiniert auszusendenden Gradientenpulsen in verschiedenen Gradientenachsen entlang verschiedener Raumrichtungen besteht. Zeitlich passend hierzu werden Auslesefenster gesetzt, welche die Zeiträume vorgeben, in denen die induzierten Magnetresonanz-Signale erfasst werden.

Bei der Magnetresonanz-Bildgebung mittels eines Magnetresonanzgeräts ist die Homogenität eines Hauptmagnetfelds in einem Untersuchungsvolumen von großer Bedeutung. Bereits bei kleinen Abweichungen der Homogenität kann es zu großen Abweichungen in einer Frequenzverteilung der Kernspins kommen, was die Qualität der Magnetresonanz-Bilddaten reduzieren kann.

Um die Homogenität im Untersuchungsvolumen zu verbessern sind Shimeinheiten bekannt. Wird ein Magnetresonanzgerät an seinen Bestimmungsort installiert, so können in der Umgebung vorhandene Felder die Homogenität des Hauptmagnetfelds, insbesondere um ein Isozentrum des Magnetresonanzgeräts herum, einschränken. Daher wird bei Installation und Inbetriebnahme eines Magnetresonanzgeräts, häufig im Zusammenhang mit Messungen, die Shimeinheit so eingestellt, dass eine möglichst optimale Homogenität hergestellt ist. Die Shimeinheit umfasst typischerweise zumindest einen Shimkasten, zumindest eine Shimkastenaufnahme und zumindest ein Shimplättchen.

Herkömmlich ist die Shimeinheit in die Gradientenspuleneinheit integriert. Die Gradientenspuleneinheit ist typischerweise hohlzylinderförmig ausgestaltet und weist an mehreren Positionen entlang der Umfangsrichtung längliche Öffnungen parallel zur Zylinderachse, insbesondere parallel zur Längsrichtung auf. Jede der derartigen länglichen Öffnungen kann als eine Shimkastenaufnahme bezeichnet werden. Die Länge der Shimkastenaufnahme in Längsrichtung entspricht typischerweise der Länge der Gradientenspuleneinheit in Längsrichtung. Die Shimkastenaufnahme kann auch kürzer als die Gradientenspuleneinheit sein und beispielsweise ausgehend von nur einem Längsende der Gradientenspuleneinheit eine Öffnung aufweisen. Die Shimkastenaufnahme ist typischerweise rohrförmig und/oder hohlzylinderförmig und/oder hohl ausgebildet. Die Shimkastenaufnahme umschließt typischerweise einen Hohlbereich. Die Shimkastenaufnahme weist typischerweise einen rechteckigen Querschnitt oder runden Querschnitt oder einen Querschnitt in Form eines Kreisringsegmentes auf. Die Shimkastenaufnahme ist typischerweise zur Aufnahme eines Shimkastens, insbesondere in deren Öffnung und/oder in deren Hohlbereich, ausgebildet. Der Shimkasten kann manuell und/oder mechanisch in der Shimkastenaufnahme, insbesondere in deren Öffnung und/oder in deren Hohlbereich, positioniert werden. Der Shimkasten ist mit der Shimkastenaufnahme vorzugsweise bündig in radiale Richtung und/oder bündig in Umfangsrichtung. Abhängig von der Inhomogenität des Hauptmagnetfelds, insbesondere aufgrund der Umgebung, sind innerhalb des Shimkastens Shimplättchen angeordnet. Die Shimplättchen sind typischerweise an definierten und individuellen Positionen innerhalb des Shimkastens angeordnet, um dank ihrer Suszeptibilität die Homogenität des Hauptmagnetfelds zu erhöhen. Typischerweise werden die Shimplättchen außerhalb der Gradientenspuleneinheit an der entsprechenden Position des Shimkastens angeordnet und gemeinsam mit dem Shimkasten innerhalb der Shimkastenaufnahme platziert, insbesondere in die Shimkastenaufnahme hineingeschoben. Herkömmlich werden Shimplättchen aus Eisen hergestellt.

Der Erfindung liegt die Aufgabe zugrunde, einen besonders platzsparenden Shimkasten anzugeben. Die Aufgabe wird durch die Merkmale der unabhängigen Ansprüche gelöst. Vorteilhafte Ausgestaltungen sind in den Unteransprüchen beschrieben.

Der erfindungsgemäße Shimkasten ist zum Einschieben in eine Shimkastenaufnahme und längsförmig mit einer Länge in Längsrichtung, einer Höhe in radialer Richtung und einer Breite in Umfangsrichtung ausgebildet. Der erfindungsgemäße Shimkasten weist zumindest zwei Shimtaschen auf, welche zumindest zwei Shimtaschen jeweils zum Aufnehmen von zumindest zwei Shimplättchen ausgebildet sind. Der erfindungsgemäße Shimkasten umfasst zumindest zwei in radialer Richtung übereinander angeordnete Shimplättchen in einer Shimtasche, wobei die Oberflächen der Shimplättchen eine isolierende Beschichtung aufweisen. Die Längsrichtung, die radiale Richtung und die Umfangsrichtung beziehen sich vorzugsweise auf eine Zylinderachse einer hohlzylindrischen Gradientenspuleneinheit und/oder eines hohlzylindrischen Magnetresonanzgerätes, in was der Shimkasten integriert werden kann. Die Längsrichtung ist dabei typischerweise parallel zur Zylinderachse.

Der Shimkasten ist typischerweise in Längsrichtung in Shimtaschen unterteilt und/oder untergliedert, welche Shimtaschen entsprechend den zu korrigierenden Inhomogenitäten des Hauptmagnetfeldes mit Shimplättchen befüllt werden können. Die Form und Größe der Shimplättchen ist typischerweise an die Größe der Shimtaschen angepasst, insbesondere in Längsrichtung und in Umfangsrichtung, sodass ein Shimplättchen insbesondere nahezu bündig in einer Shimtasche gelagert werden kann. Eine Shimtasche kann dazu ausgebildet sein, zumindest zwei, insbesondere auch drei oder mehr Shimplättchen aufzunehmen, welche übereinander angeordnet werden können, insbesondere gestapelt in radialer Richtung.

Die Oberflächen der Shimplättchen weisen eine elektrisch isolierende Beschichtung auf. Vorzugsweise weist die Oberfläche jedes einzelnen Shimplättchens eine isolierende Beschichtung auf. Vorzugsweise ist jedes der zumindest zwei Shimplättchen von einer isolierenden Beschichtung umgeben, besonders bevorzugt vollständig. Die isolierende Beschichtung der Shimplättchen kann automatisiert und gleichmäßig erfolgen, wodurch eine besonders hohe Qualität gewährleistet werden kann. Die isolierende Beschichtung vermeidet die Bildung von Spikes zwischen den Shimplättchen und der Shimtasche und/oder zwischen den Shimplättchen untereinander zuverlässig. Insbesondere kann die Isolierung der Shimplättchen unabhängig von der Befüllung einer Shimtasche mit den Shimplättchen erfolgen, wodurch ein fehleranfälliger Prozess vermieden werden kann.

Eine Ausführungsform des Shimkastens sieht vor, dass der Shimkasten frei von einer Zwischenlage zwischen den beiden übereinander angeordneten Shimplättchen ist, insbesondere die beiden übereinander angeordneten Shimplättchen direkt aufeinander aufliegen.

Die beiden übereinander angeordneten Shimplättchen weisen vorzugsweise flächigen Kontakt zueinander auf. Herkömmlich erfolgt die elektrische Isolierung zwischen zwei übereinander angeordneten Shimplättchen durch eine Schicht, insbesondere durch Isolierfolien, umfassend Kunststoff. Der Verzicht auf eine isolierende Zwischenlage zwischen den beiden übereinander angeordneten Shimplättchen ermöglicht eine Reduktion der Höhe des Shimkastens ohne Reduktion der Menge der Shimplättchen, insbesondere der Menge des die Homogenität des Hauptmagnetfeldes, also die magnetische Wirkung, beeinflussenden Materials, welches von den Shimplättchen umfasst wird. Zudem reduziert der Verzicht auf eine Zwischenlage mögliche Fehler beim Befüllen einer Shimtasche mit Shimplättchen und beschleunigt diesen Vorgang. Dies resultiert in einer robusteren Isolierung zwischen den einzelnen Shimplättchen.

Der Durchmesser des Patientenaufnahmebereiches eines Magnetresonanzgerätes korreliert mit dem Komfort des Patienten: je größer der Durchmesser der Hochfrequenzantenneneinheit, desto komfortabler für den Patienten. Typischerweise sind die Hochfrequenzantenneneinheit, die Gradientenspuleneinheit und der supraleitende Magnet zur Erzeugung des Hauptmagnetfeldes, also der Hauptmagnet, konzentrisch zueinander angeordnet. Je größer der Innendurchmesser des Hauptmagneten, desto ineffizienter kann das Hauptmagnetfeld erzeugt werden und desto mehr Maßnahmen und Kosten sind erforderlich, um eine ausreichende Homogenität des Hauptmagnetfeldes zu erzeugen. Folglich ist es erstrebenswert, dass insbesondere die innerhalb des Hauptmagneten angeordneten Einheiten, insbesondere die Hochfrequenzantenneneinheit und die Gradientenspuleneinheit, eine möglichst geringe Wanddicke aufweisen. Diese Ausführungsform des Shimkastens ermöglicht eine besonders flache Anordnung der Shimplättchen bei gleichbleibender magnetischer Wirkung.

Eine Ausführungsform des Shimkastens sieht vor, dass die zumindest zwei Shimplättchen jeweils einen Shimkern umfassend Metall, insbesondere Eisen, umfassen und die isolierende Beschichtung durch zumindest eines der folgenden Merkmale charakterisiert ist:
- passivierte Oberfläche des Shimkerns
- Phosphatierte Oberfläche des Shimkerns
- Lack
- Gasphasenabscheidung an der Oberfläche des Shimkerns.

Die Shimplättchen umfassen vorzugsweise Halbzeug. Die isolierende Beschichtung ist vorzugsweise als eine isolierende Versiegelung der Oberfläche ausgebildet. Die Dicke der isolierenden Beschichtung kann weniger als 100 um betragen. Die isolierende Beschichtung kann in Form eines Lackes auf die Oberfläche des Shimkerns aufgetragen werden. Die isolierende Beschichtung kann eine Laminierung und/oder Folierung des Shimkerns umfassen. Die isolierende Beschichtung kann mittels Passivierung der Oberfläche des Shimkerns erzeugt worden sein. Die isolierende Beschichtung kann mittels Phosphatierung der Oberfläche des Shimkerns erzeugt worden sein. Die isolierende Beschichtung kann mittels Gasphasenabscheidung, insbesondere mittels chemischer Gasphasenabscheidung oder physikalischer Gasphasenabscheidung, an der Oberfläche des Shimkerns erzeugt worden sein. Der Shimkern ist zuverlässig mit derartigen isolierenden Beschichtungen zu behandeln und vollständig zu isolieren. Eine Unterdrückung von Spike kann dadurch zuverlässig gewährleistet werden.

Eine Ausführungsform des Shimkastens sieht vor, dass der Shimkasten eine Höhe in radialer Richtung von weniger als 10 mm aufweist. Der Shimkasten weist eine Höhe in radialer Richtung typischerweise zwischen 3 mm und 10 mm, vorzugsweise zwischen 4 mm und 8 mm, besonders bevorzugt zwischen 5 mm und 7 mm auf. Der Shimkasten weist eine Breite in Umfangsrichtung typischerweise zwischen 5 mm und 100 mm, vorzugsweise zwischen 10 mm und 50 mm, besonders bevorzugt zwischen 20 mm und 40 mm auf. Der Shimkasten weist eine Länge in Längsrichtung typischerweise zwischen 700 mm und 2000 mm, vorzugsweise zwischen 800 mm und 1800 mm, besonders bevorzugt zwischen 1000 mm und 1600 mm auf. Diese Ausführungsform ermöglicht besonders platzsparendes Shimming des Hauptmagnetfeldes.

Eine Ausführungsform des Shimkastens sieht vor, dass der Shimkasten derart ausgeformt ist, dass dieser einen rechteckigen Querschnitt senkrecht zur Längsrichtung aufweist. Der Shimkasten kann innerhalb oder an die Gradientenspuleneinheit angeordnet werden. Der Shimkasten kann innerhalb oder an die Hochfrequenzantenneneinheit angeordnet werden. Der Shimkasten kann zwischen Hochfrequenzantenneneinheit und Gradientenspuleneinheit angeordnet werden. Bei all diesen Anordnungen ist die Breite des Shimkastens in Umfangsrichtung typischerweise geringer als 10% des Durchmessers der Hochfrequenzantenneneinheit und/oder Gradientenspuleneinheit. Folglich kann insbesondere bei geringer Breite des Shimkastens auf eine Krümmung des Shimkastens in Umfangsrichtung verzichtet werden. Ein Shimkasten mit rechteckigem Querschnitt senkrecht zur Längsrichtung kann insbesondere robust und einfach gefertigt werden.

Eine Ausführungsform des Shimkastens sieht vor, dass der Shimkasten derart ausgeformt ist, dass dieser einen Querschnitt entsprechend einem Kreisringsegment senkrecht zur Längsrichtung aufweist. Vorzugsweise ist die Krümmung des Kreisringsegmentes an die Krümmung der Hochfrequenzantenneneinheit und/oder Gradientenspuleneinheit in Umfangsrichtung angepasst. Der Shimkasten kann auch nur einseitig als Kreisringsegment ausgeformt sein. Diese Ausführungsform ermöglicht insbesondere bei geringer Höhe, also geringer Wanddicke der Hochfrequenzantenneneinheit und/oder Gradientenspuleneinheit, die Verwendung eines relativ breiten Shimkastens in Umfangsrichtung. Hierdurch können insbesondere größere Shimplättchen verwendet werden, wodurch insbesondere große Inhomogenitäten des Hauptmagnetfeldes korrigiert werden können. Zudem ist der halt eines derartigen Shimkastens in der passenden Shimkastenaufnahme besonders gut.

Eine Ausführungsform des Shimkastens sieht vor, dass der Shimkasten eine Trägerplatte umfasst, auf welcher Trägerplatte die Shimtaschen angeordnet sind. Die Trägerplatte ist typischerweise dazu ausgebildet, die Shimtaschen insbesondere in Längsrichtung zu stabilisieren. Die Trägerplatte weist vorzugsweise eine höhere Steifigkeit auf als die Shimtaschen. Die Trägerplatte weist typischerweise eine größere Höhe, also größere räumliche Ausdehnung in radiale Richtung, auf als eine Wand und/oder Abtrennung einer Shimtasche in Längsrichtung. Die Shimtaschen sind typischerweise derartig ausgestaltet, dass diese zur Aufnahme von Shimplättchen geeignet sind und/oder ein Herausfallen der Shimplättchen verhindern kann. Die Stabilität des Shimkastens, welche zum Hineinschieben des Shimkastens in die Shimkastenaufnahme erforderlich ist, wird vorzugsweise durch die Trägerplatte gewährleistet. Die Trägerplatte kann demnach einer Versteifung der Shimtaschen, insbesondere gegen Durchbiegung, und/oder der mechanischen Stabilität des Shimkastens dienen. Insbesondere kann die Trägerplatte massiven Kunststoff umfassen. Diese Ausführungsform ermöglicht einen besonders robusten Shimkasten.

Eine Ausführungsform des Shimkastens sieht vor, dass die Trägerplatte und/oder die Shimtaschen glasfaserverstärkten Kunststoff (GFK) oder kohlenstofffaserverstärkter Kunststoff (CFK) umfassen. Gemäß dieser Ausführungsform sind ausgenommen der Shimplättchen vorzugsweise alle Teile des Shimkastens aus GFK oder CFK ausgebildet. GFK und/oder CFK sind besonders robuste und stabile Kunststoffe, die eine besondere Belastbarkeit und Stabilität hinsichtlich Vibrationen und Drehmomenten aufweisen. Zudem ist GFK und/oder CFK elektrisch isolierend, was Wirbelströme und/oder eine elektromagnetische Beeinflussung der Shimplättchen reduziert. Dies ermöglicht einen Shimkasten mit einer besonders dünnen Trägerplatte bei zugleich hoher Stabilität.

Eine Ausführungsform des Shimkastens sieht vor, dass die Trägereinheit eine Versteifungseinheit umfasst. Die Versteifungseinheit ist vorzugsweise derart ausgebildet, dass diese die Stabilität der Trägerplatte und damit des Shimkastens erhöht. Die Trägerplatte weist in Umfangsrichtung vorzugsweise eine größere Breite auf als die Shimtasche, steht also seitlich über die Shimtasche hinaus. Insbesondere in diesen Bereichen des seitlichen Überstandes kann die Versteifungseinheit angeordnet sein. Die Versteifungseinheit ist vorzugsweise länglich in Längsrichtung ausgebildet. Dies ermöglicht einen Shimkasten mit einer besonders dünnen Trägerplatte bei zugleich hoher Stabilität.

Eine Ausführungsform des Shimkastens sieht vor, dass die Versteifungseinheit eine Wabenstruktur und/oder eine Stabform und/oder GFK und/oder CFK umfasst. Die Wabenstruktur und/oder die Stabform sind vorzugsweise länglich in Längsrichtung ausgebildet. Die Wabenstruktur und/oder die Stabform sind vorzugsweise seitlich der Shimtaschen angeordnet. Die Stabform weist vorzugsweise einen rechteckigen Querschnitt senkrecht zur Längsrichtung auf. Dies ermöglicht einen Shimkasten mit einer besonders dünnen Trägerplatte bei zugleich hoher Stabilität.

Des Weiteren geht die Erfindung aus von einer Gradientenspuleneinheit mit einer Shimkastenaufnahme ausgebildet zum Aufnehmen eines erfindungsgemäßen Shimkastens. Der Shimkasten kann vorzugsweise manuell in die Shimkastenaufnahme geschoben werden. Die Maße der Shimkastenaufnahme, insbesondere in radiale Richtung und in Umfangsrichtung, sind vorzugsweise auf die Maße des Shimkastens abgestimmt, sodass dieser überwiegend bündig innerhalb der Shimkastenaufnahme angeordnet werden kann. Die Gradientenspuleneinheit ist hohlzylinderförmig ausgebildet und weist zumindest eine Öffnung in Längsrichtung auf, welche als Shimkastenaufnahme dienen kann. Die Gradientenspuleneinheit umfasst typischerweise zumindest vier, vorzugsweise zumindest acht, besonders bevorzugt zumindest zwölf Shimkastenaufnahmen, welche an verschiedenen Positionen in Umfangsrichtung angeordnet sind und jeweils länglich ausgestaltet sind und parallel zur Längsrichtung und/oder Zylinderachse verlaufen. Die von der Gradientenspuleneinheit umfassten Shimkastenaufnahmen sind vorzugsweise in Umfangsrichtung gleichmäßig verteilt und/oder symmetrisch angeordnet.

Eine Ausführungsform der Gradientenspuleneinheit umfasst eine Primärspuleneinheit zur Erzeugung eines Magnetfeldgradienten und ist frei von einer Sekundärspuleneinheit. Die Primärspuleneinheit kann drei Primärspulen umfassen, wobei jeweils eine der drei Primärspulen dazu ausgebildet ist, jeweils einen Magnetfeldgradienten in eine von drei zueinander orthogonalen Raumrichtungen zu erzeugen. Die Primärspuleneinheit ist typischerweise zur Erzeugung eines Magnetfeldgradienten im Patientenaufnahmebereich ausgebildet.

Herkömmlich wird die Wirkung der Primärspuleneinheit außerhalb des Patientenaufnahmebereiches durch eine der Primärspuleneinheit zugeordnete Sekundärspuleneinheit weitgehend unterdrückt. Die Sekundärspuleneinheit umgibt herkömmlich die entsprechende Primärspuleneinheit konzentrisch. Je größer der radiale Abstand zwischen der Primärspuleneinheit und einer herkömmlichen Sekundärspuleneinheit, desto geringer ist die Wirkung von Wirbelströmen höherer Ordnung auf die Primärspuleneinheit, was die Homogenität des von der Gradientenspuleneinheit erzeugten Magnetfeldgradienten verbessert. Der radiale Abstand zwischen der Primärspuleneinheit und einer herkömmlichen Sekundärspuleneinheit kann demnach bei einer herkömmlichen Gradientenspuleneinheit für die Integration von Shimkastenaufnahmen verwendet werden, ohne dass der Durchmesser des Patientenaufnahmebereiches davon beeinflusst wird. Ist die Gradientenspuleneinheit frei von einer Sekundärspuleneinheit, so kann sich die Höhe des Shimkastens auf den Durchmesser des Patientenaufnahmebereiches auswirken, welcher um die Höhe des Shimkastens in radialer Richtung verringert werden kann. Folglich ist für diese Ausführungsform der Gradientenspuleneinheit ein Shimkasten mit besonders geringer Höhe, wie der erfindungsgemäße Shimkasten, besonders vorteilhaft.

Des Weiteren geht die Erfindung aus von einem Magnetresonanzgerät umfassend einen Hauptmagneten, eine Hochfrequenzantenneneinheit, eine Gradientenspuleneinheit, eine Shimkastenaufnahme und einen erfindungsgemäßen Shimkasten. Die Shimkastenaufnahme kann gemäß der erfindungsgemäßen Gradientenspuleneinheit in die Gradientenspuleneinheit integriert sein.

Eine Ausführungsform des Magnetresonanzgerätes sieht vor, dass der Shimkasten und die Shimkastenaufnahme zwischen dem Hauptmagneten und der Gradientenspuleneinheit oder zwischen der Gradientenspuleneinheit und der Hochfrequenzantenneneinheit oder integriert in die Hochfrequenzantenneneinheit angeordnet sind.

Ausführungsformen des erfindungsgemäßen Magnetresonanzgerätes und der erfindungsgemäßen Gradientenspuleneinheit sind analog zu den Ausführungsformen des erfindungsgemäßen Shimkastens ausgebildet. Die Vorteile des erfindungsgemäßen Magnetresonanzgeräts und der erfindungsgemäßen Gradientenspuleneinheit entsprechen im Wesentlichen den Vorteilen des erfindungsgemäßen Shimkastens, welche vorab im Detail ausgeführt sind. Hierbei erwähnte Merkmale, Vorteile oder alternative Ausführungsformen können ebenso auch auf die anderen beanspruchten Gegenstände übertragen werden und umgekehrt.

Weitere Vorteile, Merkmale und Einzelheiten der Erfindung ergeben sich aus den im Folgenden beschriebenen Ausführungsbeispielen sowie anhand der Zeichnungen.

Es zeigen:
- Fig. 1: eine erste Ausführungsform eines erfindungsgemäßen Shimkastens in einer schematischen Darstellung in einer ersten Ansicht,
- Fig. 2: eine zweite Ausführungsform eines erfindungsgemäßen Shimkastens in einer schematischen Darstellung in einer ersten Ansicht,
- Fig. 3: eine dritte Ausführungsform eines erfindungsgemäßen Shimkastens in einer schematischen Darstellung in einer ersten Ansicht,
- Fig. 4: eine vierte Ausführungsform eines erfindungsgemäßen Shimkastens in einer schematischen Darstellung in einer ersten Ansicht,
- Fig. 5: eine fünfte Ausführungsform eines erfindungsgemäßen Shimkastens in einer schematischen Darstellung in einer zweiten Ansicht,
- Fig. 6: eine sechste Ausführungsform eines erfindungsgemäßen Shimkastens in einer schematischen Darstellung in einer ersten Ansicht,
- Fig. 7: eine sechste Ausführungsform eines erfindungsgemäßen Shimkastens in einer schematischen Darstellung in einer zweiten Ansicht,
- Fig. 8: eine siebte Ausführungsform eines erfindungsgemäßen Shimkastens in einer schematischen Darstellung in einer zweiten Ansicht,
- Fig. 9: eine achte Ausführungsform eines erfindungsgemäßen Shimkastens in einer schematischen Darstellung in einer zweiten Ansicht,
- Fig. 10: eine erste Ausführungsform einer erfindungsgemäßen Gradientenspuleneinheit in einer schematischen Darstellung,
- Fig. 11: eine erste Ausführungsform eines erfindungsgemäßen Magnetresonanzgerätes in einer schematischen Darstellung in einer ersten Ansicht,
- Fig. 12: eine zweite Ausführungsform eines erfindungsgemäßen Magnetresonanzgerätes in einer schematischen Darstellung in einer zweiten Ansicht, und
- Fig. 13: eine dritte Ausführungsform eines erfindungsgemäßen Magnetresonanzgerätes in einer schematischen Darstellung in einer zweiten Ansicht.

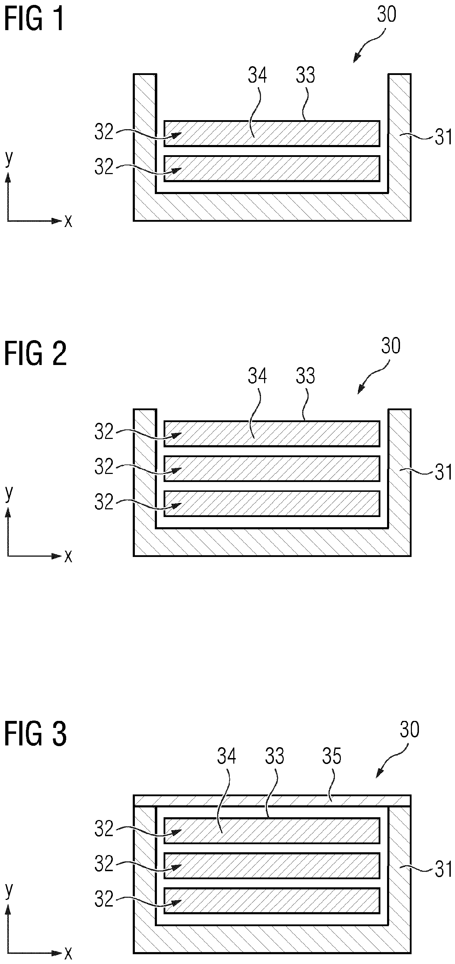

Figur 1 zeigt eine erste Ausführungsform eines erfindungsgemäßen Shimkastens 30 in einer schematischen Darstellung in einer ersten Ansicht. Der Shimkasten 30 ist längsförmig mit einer Länge in Längsrichtung z, einer Höhe in radialer Richtung r, die im dargestellten Fall der y-Richtung entspricht, und einer Breite in Umfangsrichtung, die im dargestellten Fall der x-Richtung entspricht, ausgebildet. Die hier angegebenen kartesischen Koordinaten entsprechen den Zylinderkoordinaten des Magnetresonanzgerätes 11 und/oder der Gradientenspuleneinheit 19 für den Fall, dass der Shimkasten 30 in der höchsten vertikalen Position angeordnet ist.

Der Shimkasten 30 weist zumindest zwei Shimtaschen 31 auf, wovon in der dargestellten ersten Ansicht lediglich der Querschnitt einer einzelnen Shimtasche 31 dargestellt wird. Jeweils eine Shimtasche 31 ist zum Aufnehmen von zumindest zwei Shimplättchen 32 ausgebildet. Die in Figur 1 vereinfacht dargestellte Shimtasche 31 ist zur Aufnahme von drei Shimplättchen 32 ausgebildet, wobei in der dargestellte Ausführungsform zwei Shimplättchen 32 übereinander, insbesondere aufeinander angeordnet sind. Jedes Shimplättchen 32 umfasst an der Oberfläche eine isolierende Beschichtung 33, welche vorzugsweise einen Shimkern 34 umgibt. Die beiden Shimplättchen 32, oder alle in der Shimtasche 31 übereinander angeordneten Shimplättchen 32, liegen vorzugsweise aufeinander auf, typischerweise mit direktem Kontakt zueinander und/oder frei von einer zwischenliegenden Schicht, insbesondere frei von einer Zwischenlage und/oder frei von einem Abstandshalter. Der in den Figuren 1 bis 4 und 6 dargestellte Abstand zwischen benachbarten Shimplättchen 32 dient lediglich einer klareren Darstellung der einzelnen Shimplättchen 32. Tatsächlich liegen die Shimplättchen 32 bevorzugt direkt aufeinander auf und/oder das unterste Shimplättchen 32 liegt vorzugsweise direkt auf dem Boden der Shimtasche 31 auf. Der in den Figuren 1 bis 7 dargestellte Abstand zwischen je einem Shimplättchen 32 und einer das Shimplättchen 32 aufnehmenden Shimtasche 31 dient lediglich einer klareren Darstellung der einzelnen Shimplättchen 32. Tatsächlich liegen die Shimplättchen 32 bevorzugt bündig mit der Shimtasche 31 und/oder weisen eine an die Größe und/oder Form der Shimtasche 31 angepasste Größe und/oder Form auf, sodass insbesondere der Abstand weniger als 5 mm, bevorzugt weniger als 3 mm, besonders bevorzugt weniger als 1 mm beträgt.

Die beiden Shimplättchen 32 umfassen jeweils einen Shimkern 34 aus Metall, insbesondere aus Eisen. Die Höhe, also die räumliche Ausdehnung des Shimkastens 30 in radiale Richtung, also im dargestellten Fall in y-Richtung, beträgt vorzugsweise weniger als 10mm, besonders bevorzugt zwischen 4mm und 8mm. Die Breite, also die räumliche Ausdehnung des Shimkastens 30 in Umfangsrichtung, also im dargestellten Fall in x-Richtung, beträgt typischerweise zwischen 5 mm und 70 mm, bevorzugt zwischen 10 mm und 50 mm, besonders bevorzugt zwischen 20 mm und 40 mm. Die Länge, also die räumliche Ausdehnung des Shimkastens 30 in Längsrichtung z, beträgt typischerweise zwischen 700 mm und 2000 mm, bevorzugt zwischen 800 mm und 1800 mm, besonders bevorzugt zwischen 1000 mm und 1600 mm. Der in Figur 1 dargestellte Querschnitt des Shimkastens 30 entspricht der Ansicht einer Schnittebene senkrecht zur Längsrichtung z und stellt eine rechteckige Form des Shimkastens 30 dar.

Figur 2 zeigt eine zweite Ausführungsform eines erfindungsgemäßen Shimkastens 30 in einer schematischen Darstellung in einer ersten Ansicht. Die zweite Ausführungsform unterscheidet sich von der ersten Ausführungsform lediglich darin, dass drei Shimplättchen 32 in der Shimtasche 31 angeordnet sind.

Figur 3 zeigt eine dritte Ausführungsform eines erfindungsgemäßen Shimkastens 30 in einer schematischen Darstellung in einer ersten Ansicht. Die dritte Ausführungsform unterscheidet sich von der zweiten Ausführungsform eines Shimkastens 30 gemäß Figur 2 darin, dass der Shimkasten 30, insbesondere die Shimtasche 31 und darin positionierte Shimplättchen 32, von einem Shimtaschendeckel 35 bedeckt ist. Der Shimtaschendeckel 35 ist dazu ausgebildet,

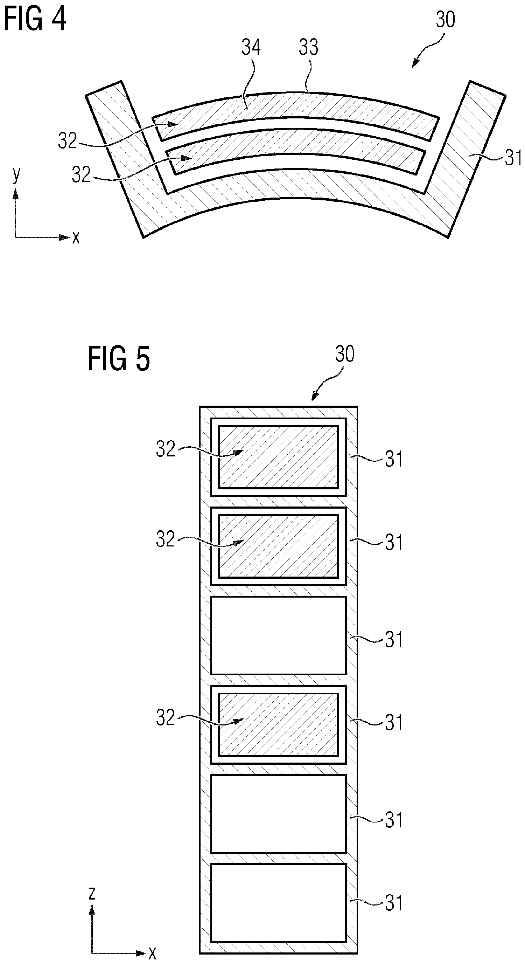

Figur 4 zeigt eine vierte Ausführungsform eines erfindungsgemäßen Shimkastens 30 in einer schematischen Darstellung in einer ersten Ansicht. Die vierte Ausführung unterscheidet sich von der ersten Ausführungsform insbesondere darin, dass der Shimkasten 30 derart ausgeformt ist, dass dieser einen Querschnitt entsprechend einem Kreisringsegment senkrecht zur Längsrichtung z aufweist.

Figur 5 zeigt eine fünfte Ausführungsform eines erfindungsgemäßen Shimkastens 30 in einer schematischen Darstellung in einer zweiten Ansicht. Die in den Figuren 1, 2 und 4 dargestellten Ausführungsformen des Shimkastens 30 können der fünften Ausführungsform entsprechen, wobei die jeweilige erste Ansicht der Figuren 1 und/oder 2, oder 4, eine Schnittebene senkrecht zur Längsrichtung z durch eine mit zumindest zwei Shimplättchen 32 belegte Shimtasche 31 darstellen kann. Der Shimkasten 30 umfasst typischerweise mehrere Shimtaschen 31, welche sich in Längsrichtung z unterscheiden, insbesondere Längsrichtung z hintereinander angeordnet sind. Die mehreren Shimtaschen 31 eines Shimkastens 30 weisen vorzugsweise eine gleiche Position in Umfangsrichtung, im dargestellten Fall in x-Richtung, auf. Die einzelnen Shimtaschen 31 eines Shimkastens 30 können mit unterschiedlicher Anzahl an Shimplättchen 32 belegt sein. Insbesondere kann zumindest eine Shimtasche 31 frei von einem Shimplättchen 32 sein.

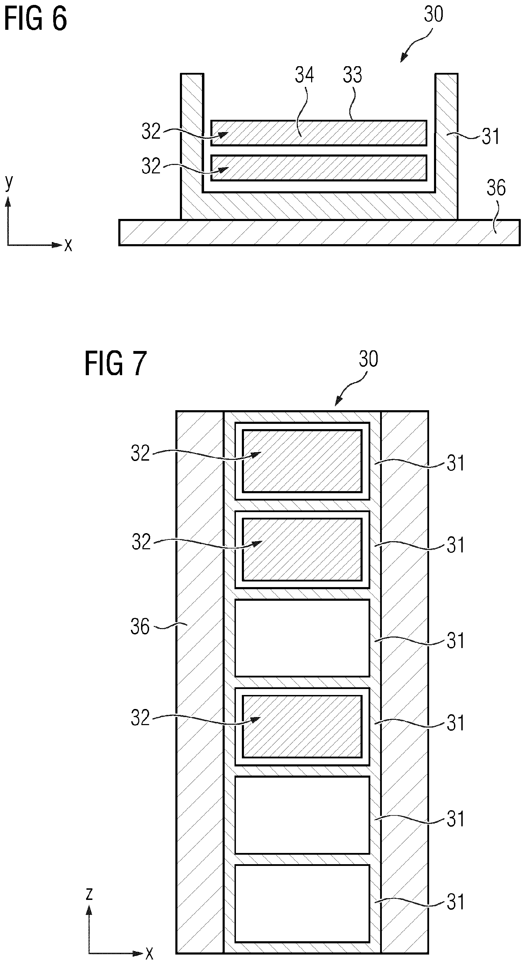

Figur 6 zeigt eine sechste Ausführungsform eines erfindungsgemäßen Shimkastens 30 in einer schematischen Darstellung in einer ersten Ansicht. Diese Ausführungsform unterscheidet sich von der in Figur 1 dargestellten ersten Ausführungsform des Shimkastens 30 darin, dass der Shimkasten 30 eine Trägerplatte 36 umfasst, auf welcher Trägerplatte 36 die Shimtaschen 31 angeordnet sind.

Figur 7 zeigt die sechste Ausführungsform eines erfindungsgemäßen Shimkastens 30 in einer zweiten Ansicht. Gemäß dieser Ausführungsform weist die Trägerplatte 36 eine größere Breite auf als die Shimtaschen 31. Die Breite der Trägerplatte 36 kann alternativ der Breite einer Shimtasche 31 entsprechen oder schmäler als diese sein.

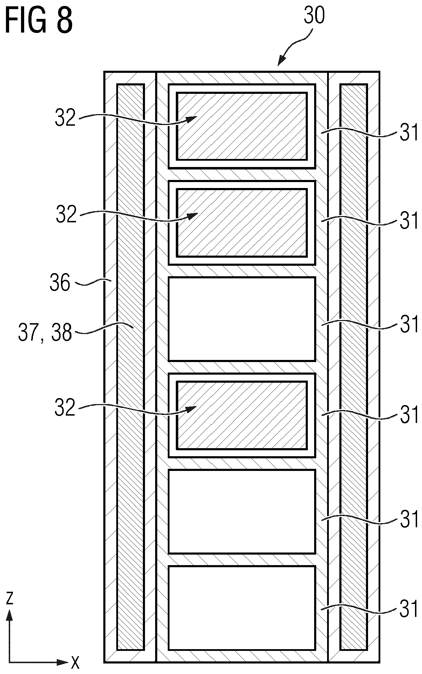

Figur 8 zeigt eine siebte Ausführungsform eines erfindungsgemäßen Shimkastens 30 in einer schematischen Darstellung in einer zweiten Ansicht. Die siebte Ausführungsform unterscheidet sich von der in Figur 7 dargestellten sechsten Ausführungsform des Shimkastens 30 insbesondere darin, dass die Trägereinheit 36 eine Versteifungseinheit 37 umfasst. Gemäß dieser Ausführungsform ist die Versteifungseinheit 37 in Stabform 38 ausgebildet und/oder umfasst GFK und/oder CFK.

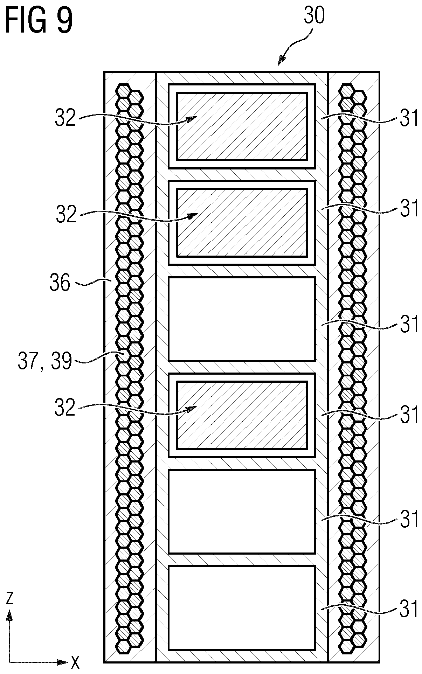

Figur 9 zeigt eine achte Ausführungsform eines erfindungsgemäßen Shimkastens in einer schematischen Darstellung in einer zweiten Ansicht. Die achte Ausführungsform unterscheidet sich von der in Figur 7 dargestellten sechsten Ausführungsform des Shimkastens 30 insbesondere darin, dass die Trägereinheit 36 eine Versteifungseinheit 37 umfasst. Gemäß dieser Ausführungsform ist die Versteifungseinheit 37 als Wabenstruktur 39 ausgebildet.

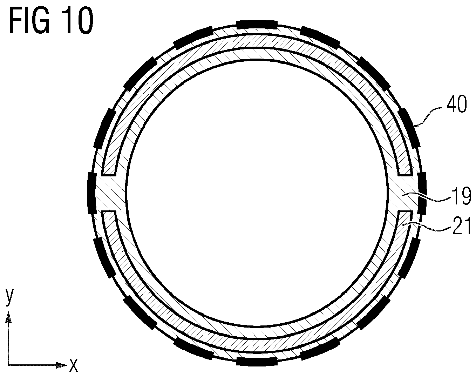

Figur 10 zeigt eine erste Ausführungsform einer erfindungsgemäßen Gradientenspuleneinheit 19 in einer schematischen Darstellung. Die Gradientenspuleneinheit 19 ist hohlzylinderförmig und mit einer Shimkastenaufnahme 40 ausgebildet, welche Shimkastenaufnahme 40 zum Aufnehmen eines erfindungsgemäßen Shimkastens 30 geeignet ist. Typischerweise weist die Gradientenspuleneinheit 19 mehrere Shimkastenaufnahmen 40 mit gleichem radialen Abstand zur Zylinderachse der Gradientenspuleneinheit auf, welche sich voneinander in ihrer Position in Umfangsrichtung unterscheiden. Typischerweise kann in jeder der mehreren Shimkastenaufnahmen 40 jeweils ein erfindungsgemäßer Shimkasten 30 positioniert werden. Die Gradientenspuleneinheit 19 weist typischerweise eine Primärspuleneinheit 21 zur Erzeugung eines Magnetfeldgradienten auf. Die Gradientenspuleneinheit 19 ist vorzugsweise frei von einer Sekundärspuleneinheit.

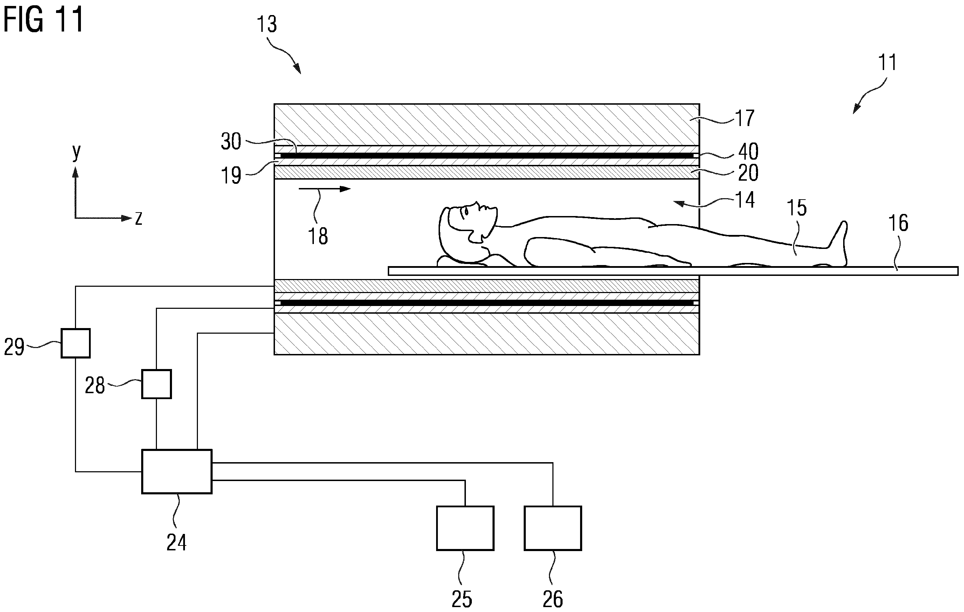

Figur 11 zeigt eine erste Ausführungsform eines erfindungsgemäßen Magnetresonanzgerätes 11 in einer schematischen Darstellung in einer ersten Ansicht. Das Magnetresonanzgerät 11 umfasst eine Detektoreinheit 13 mit einem Hauptmagneten 17 zu einem Erzeugen eines starken und insbesondere konstanten Hauptmagnetfelds 18 parallel zur Längsrichtung z, insbesondere parallel zur Zylinderachse. Zudem weist das Magnetresonanzgerät 11 einen zylinderförmigen Patientenaufnahmebereich 14 zu einer Aufnahme eines Patienten 15 auf, wobei der Patientenaufnahmebereich 14 in einer Umfangsrichtung von der Detektoreinheit 13 zylinderförmig umschlossen ist. Der Patient 15 kann mittels einer Patientenlagerungsvorrichtung 16 des Magnetresonanzgeräts 11 in den Patientenaufnahmebereich 14 geschoben werden. Die Patientenlagerungsvorrichtung 16 weist hierzu einen Patiententisch auf, der bewegbar innerhalb des Magnetresonanzgeräts 11 angeordnet ist. Die Detektoreinheit 13 weist weiterhin eine Hochfrequenzantenneneinheit 20, welche im gezeigten Fall als fest in das Magnetresonanzgerät 11 integrierte Körperspule ausgebildet ist, und eine Hochfrequenzantennensteuereinheit 29 zu einer Anregung einer Polarisation, die sich in dem von dem Hauptmagneten 17 erzeugten Hauptmagnetfeld 18 einstellt, auf. Die Hochfrequenzantenneneinheit 20 wird von der Hochfrequenzantennensteuereinheit 29 angesteuert und strahlt hochfrequente Hochfrequenz-Pulse in einen Untersuchungsraum, der im Wesentlichen von dem Patientenaufnahmebereich 14 gebildet ist, ein.

Des Weiteren weist die Detektoreinheit 13 eine Gradientenspuleneinheit 19 auf, die für eine Ortskodierung während einer Bildgebung verwendet werden. Die Gradientenspuleneinheit 19 wird mittels einer Gradientensteuereinheit 28 angesteuert. Zudem weist die Detektoreinheit 13, insbesondere in der in Figur 11 dargestellten Ausführungsform die Gradientenspuleneinheit 19, eine Shimkastenaufnahme 40 ausgebildet zum Aufnehmen eines erfindungsgemäßen Shimkastens 30 auf.

Zu einer Steuerung des Hauptmagneten 17, der Gradientensteuereinheit 28 und der Hochfrequenzantennensteuereinheit 29 weist das Magnetresonanzgerät 11 eine Steuerungseinheit 24 auf. Die Steuerungseinheit 24 steuert zentral das Magnetresonanzgerät 11, wie beispielsweise das Durchführen von MR-Steuerungssequenzen. Das Magnetresonanzgerät 11 weist eine Anzeigeeinheit 25 auf. Zudem weist das Magnetresonanzgerät 11 eine Eingabeeinheit 26 auf, mittels derer Informationen und/oder Steuerungsparameter während eines Messvorgangs von einem Benutzer eingegeben werden können. Die Steuerungseinheit 24 kann die Gradientensteuereinheit 28 und/oder Hochfrequenzantennensteuereinheit 29 und/oder die Anzeigeeinheit 25 und/oder die Eingabeeinheit 26 umfassen.

Das dargestellte Magnetresonanzgerät 11 kann selbstverständlich weitere Komponenten umfassen, die Magnetresonanzgeräte 11 gewöhnlich aufweisen. Eine allgemeine Funktionsweise eines Magnetresonanzgeräts 11 ist zudem dem Fachmann bekannt, so dass auf eine detaillierte Beschreibung der weiteren Komponenten verzichtet wird.

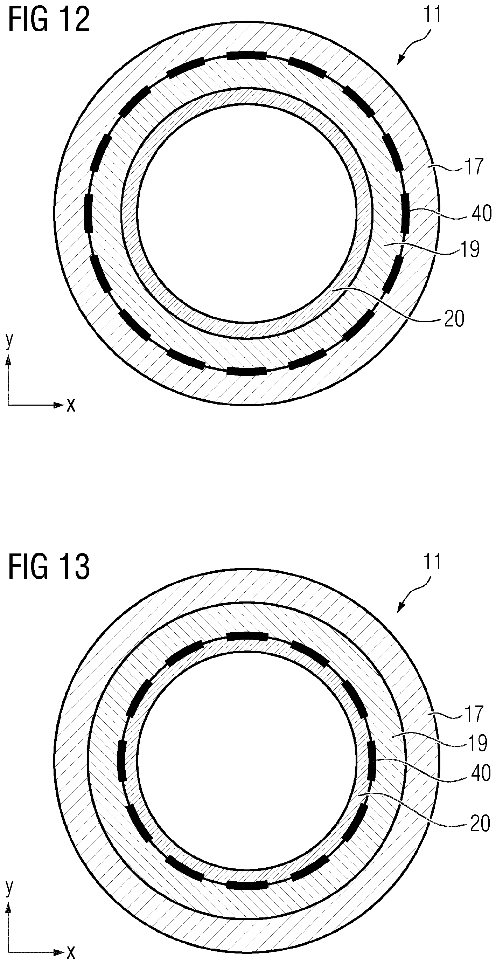

Figur 12 zeigt eine zweite Ausführungsform eines erfindungsgemäßen Magnetresonanzgerätes in einer schematischen Darstellung in einer zweiten Ansicht. Gemäß der zweiten Ausführungsform weist das Magnetresonanzgerät eine Mehrzahl an Shimkastenaufnahmen 40 und darin positionierte Shimkästen 30 auf. Die Shimkastenaufnahmen 40 und die Shimkästen 30 sind gemäß der zweiten Ausführungsform zwischen dem Hauptmagneten 17 und der Gradientenspuleneinheit 19 angeordnet.

Figur 13 zeigt eine dritte Ausführungsform eines erfindungsgemäßen Magnetresonanzgerätes in einer schematischen Darstellung in einer zweiten Ansicht. Gemäß der dritten Ausführungsform weist das Magnetresonanzgerät eine Mehrzahl an Shimkastenaufnahmen 40 und darin positionierte Shimkästen 30 auf. Die Shimkastenaufnahmen 40 und die Shimkästen 30 sind gemäß der dritten Ausführungsform zwischen der Gradientenspuleneinheit 19 und der Hochfrequenzantenneneinheit 20 angeordnet. Zugleich oder alternativ können die Shimkastenaufnahmen 40 und die Shimkästen 30 integriert in die Hochfrequenzantenneneinheit 20 angeordnet sein.

Obwohl die Erfindung im Detail durch die bevorzugten Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen. Unabhängig vom grammatikalischen Geschlecht eines bestimmten Begriffes sind Personen mit männlicher, weiblicher oder anderer Geschlechteridentität mit umfasst.

## Patentansprüche

1. Shimkasten ausgebildet zum Einschieben in eine Shimkastenaufnahme,
welcher Shimkasten längsförmig mit einer Länge in Längsrichtung, einer Höhe in radialer Richtung und einer Breite in Umfangsrichtung ausgebildet ist,
aufweisend zumindest zwei Shimtaschen jeweils ausgebildet zum Aufnehmen von zumindest zwei Shimplättchen,
und umfassend zumindest zwei in radialer Richtung übereinander angeordnete Shimplättchen in einer Shimtasche,
wobei die Oberflächen der zumindest zwei Shimplättchen eine isolierende Beschichtung aufweisen.

2. Shimkasten nach Anspruch 1, wobei
der Shimkasten frei von einer Zwischenlage zwischen den beiden übereinander angeordneten Shimplättchen ist,
insbesondere die beiden übereinander angeordneten Shimplättchen direkt aufeinander aufliegen.

3. Shimkasten nach einem der vorangehenden Ansprüche, wobei die zumindest zwei Shimplättchen jeweils einen Shimkern umfassend Metall, insbesondere Eisen, umfassen und die isolierende Beschichtung durch zumindest eines der folgenden Merkmale charakterisiert ist:
- passivierte Oberfläche des Shimkerns
- Phosphatierte Oberfläche des Shimkerns
- Lack
- Gasphasenabscheidung an der Oberfläche des Shimkerns.

4. Shimkasten nach einem der vorangehenden Ansprüche, wobei der Shimkasten eine Höhe in radialer Richtung von weniger als 10 mm aufweist.

5. Shimkasten nach einem der vorangehenden Ansprüche, wobei der Shimkasten derart ausgeformt ist, dass dieser einen rechteckigen Querschnitt senkrecht zur Längsrichtung aufweist.

6. Shimkasten nach einem der vorangehenden Ansprüche, wobei der Shimkasten derart ausgeformt ist, dass dieser einen Querschnitt entsprechend einem Kreisringsegment senkrecht zur Längsrichtung aufweist.

7. Shimkasten nach einem der vorangehenden Ansprüche, wobei der Shimkasten eine Trägerplatte umfasst, auf welcher Trägerplatte die Shimtaschen angeordnet sind.

8. Shimkasten nach Anspruch 7, wobei
die Trägerplatte und/oder die Shimtaschen glasfaserverstärkten Kunststoff (GFK) oder kohlenstofffaserverstärkter Kunststoff (CFK) umfassen.

9. Shimkasten nach einem der Ansprüche 7 bis 8, wobei
die Trägereinheit eine Versteifungseinheit umfasst.

10. Shimkasten nach Anspruch 9, wobei
die die Versteifungseinheit eine Wabenstruktur und/oder eine Stabform und/oder GFK und/oder CFK umfasst.

11. Gradientenspuleneinheit mit einer Shimkastenaufnahme ausgebildet zum Aufnehmen eines Shimkastens nach einem der vorangehenden Ansprüche.

12. Gradientenspuleneinheit nach Anspruch 11, umfassend eine Primärspuleneinheit zur Erzeugung eines Magnetfeldgradienten und frei von einer Sekundärspuleneinheit.

13. Magnetresonanzgerät umfassend einen Hauptmagneten, eine Hochfrequenzantenneneinheit, eine Gradientenspuleneinheit, eine Shimkastenaufnahme und einen Shimkasten nach einem der Ansprüche 1 bis 9.

14. Magnetresonanzgerät nach Anspruch 13,
wobei der Shimkasten und die Shimkastenaufnahme zwischen dem Hauptmagneten und der Gradientenspuleneinheit oder zwischen der Gradientenspuleneinheit und der Hochfrequenzantenneneinheit oder integriert in die Hochfrequenzantenneneinheit angeordnet sind.
